# EUROPEAN PATENT APPLICATION

(11) **EP 4 679 068 A1**
(43) Date of publication of application: **14.01.2026**
(21) Application number: 24188469.1
(22) Date of filing: 12.07.2024
(51) Int. Cl.: G01N 23/2251, H01J 37/26

(54) **METHOD OF TIME-RESOLVED CHARGED PARTICLE MICROSCOPY**

(71) Applicant: FEI Company, Hillsboro, OR 97124 (US)
(72) Inventor: Hendriksen, Bas, 5651GG Eindhoven (NL); De Ruiter, Jolet, 5651GG Eindhoven (NL)
(74) Representative: Robinson, Louise Frances

(57) **Abstract**

The invention relates to a method of time-resolved charged particle microscopy, comprising the step of providing a sample for charged particle microscopy, wherein said sample comprises a first particle and a second particle, and wherein said sample comprises a barrier material between said first particle and said second particle. The method further comprises the step of liquifying at least a part of the barrier material for enabling an interaction between the first particle and the second particle. Finally, the resulting interaction between the first particle and the second particle can be observed in a charged particle microscope.

## Description

The disclosure relates to a method of time-resolved charged particle microscopy.

Charged-particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (e.g. a FIB-SEM), which additionally employ a "machining" Focused Ion Beam (FIB), allowing supportive activities such as ion-beam milling or lon-Beam-Induced Deposition (IBID), for example. More specifically:
- In a SEM, irradiation of a sample by a scanning electron beam precipitates emanation of "auxiliary" radiation from the sample, in the form of secondary electrons, backscattered electrons, X-rays and photoluminescence (infrared, visible and/or ultraviolet photons), for example; one or more components of this flux of emanating radiation is/are then detected and used for image accumulation purposes.
- In a TEM, the electron beam used to irradiate the sample is chosen to be of a high-enough energy to penetrate the sample (which, to this end, will generally be thinner than in the case of an SEM sample); the flux of transmitted electrons emanating from the sample can then be used to create an image. When such a TEM is operated in scanning mode (thus becoming a STEM), the image in question will be accumulated during a scanning motion of the irradiating electron beam.

There is a desire to study (bio)chemistry experiments in more detail, both in terms of spatial detail and time detail. Being able to study (bio)chemistry experiments in a charged particle microscope would allow one to see more spatial details of the experiments. However, time constants for (bio)chemistry reactions are very low, which puts a constraint on sample preparation.

In prior art documents, such as EP1803141A1, use is made of micro-reactors for observing particles or parts thereof in a fluid. These micro-reactors comprise two cover layers that are kept a small distance apart from each other with spacers. The two cover layers thus define a channel, to which channel an inlet and an outlet is provided. Hereby a fluid can be introduced in the channel. Each cover layer shows a multitude of recesses that are sufficiently thin to be transparent for the electrons used in the TEM. The recesses are placed in such a manner, that an electron beam impinging perpendicular to a cover layer and travelling through one recess also passes through a corresponding recess in the other cover layer. Thereby the fluid and any particles and/or cells within the fluid between two corresponding recesses can be observed by the TEM.

Another micro-reactor device is known from EP2316565A1 in name of applicant.

These micro-reactors are technologically complex, and have the disadvantage that not all parts of the micro-reactors are transparent to the electrons, which leads to the fact that studying (bio)chemical reactions in a time-resolved manner, using a charged particle microscope, is very time-consuming and challenging.

It is thus an object of the disclosure to provide a method of time-resolved charged particle microscopy that solves at least one of the drawbacks of the prior art.

To this end, the disclosure provides a method of time-resolved charged particle microscopy as defined in claim 1.

The method as defined herein comprises the step of providing a sample for charged particle microscopy, wherein said sample comprises a first particle and a second particle, and wherein said sample comprises a barrier material between said first particle and said second particle.

As defined herein, the method comprises the step of liquifying at least a part of the barrier material for enabling an interaction between the first particle and the second particle. By using a barrier material, such as vitreous ice, the first particle and the second particle can be kept separated from each other until a desired moment in time. The barrier material may thus be arranged to prevent the first particle and the second particle from interacting with each other.

The barrier material as defined herein is arranged to be liquifiable, meaning that it can be brought to a fluid-like state for at least partly removing the barrier between the first particle and the second particle. By liquifying the barrier material it is possible that the first particle and second particle can be brought into contact with each other. This may be due to Brownian motion of particles, which leads to diffusion of particles, so that the first particle and the second particle are able to encounter each other. The liquified barrier material may provide the medium in which the first particle and the second particle exhibit Brownian motion. In other words, the liquified barrier material may act as a solvent for the first particle and the second particle. And when the particles encounter each other, they may interact with each other. The resulting interaction between the first particle and the second particle, which can be a chemical reaction or a protein-protein interaction, can then be observed in a charged particle microscope, such as a (Cryo-) Transmission Electron Microscope.

With this, an improved method for observing interactions between particles is provided. The method provided does not require the use of expensive and complicated mini-reactors. In contrast, it uses a liquifiable barrier material, which can be relatively cheap and can be applied to standard grids that are used in charged particle microscopy. In effect, an improved method for time-resolved charged particle microscopy is provided, with which the object as defined herein is achieved.

Advantageous embodiments will be described below.

In an embodiment, the step of liquifying the barrier material comprises the step of heating said barrier material. Heating the barrier material can be done in a very precise manner, in terms of space and time. As an example, heating may be applied locally, so that locally there can be interactions between the first particle and the second particle. Heating may also be applied in different time intervals, and for different durations.

There are different ways that heating can be applied to a sample for charged particle microscopy, so that the barrier material is liquified.

In an embodiment, a laser is used for liquifying the barrier material. A laser is able to apply heating very locally, so that interactions between the first particle and the second particle can take place very locally. A laser is also suitable to apply heating in a very controlled manner.

In an embodiment, a charged particle beam of the charged particle microscope is used for liquifying the barrier material. The charged particle beam may be a focused ion beam, which allows at least part of the barrier material between the first particle and the second particle to be removed so that the first particle and second particle may interact with each other.

In a further embodiment, the sample comprises heat absorbing particles, such as gold particles. These gold particles are able to absorb heat so that the barrier material surrounding the gold particles can be liquified.

In an embodiment, a charged particle beam may be used to heat the heat absorbing particles for subsequently liquifying the barrier material. The charged particle beam may be an electron beam that is used to illuminate a part of the sample. This way, the barrier material can be liquified right before and during the observation of the interaction between the first particle and the second particle.

In an embodiment, the method comprises the step of re-solidifying the barrier material, after the step of liquifying said barrier material. Liquifying and re-solidifying the barrier material allows more time for observing the interactions between the first particle and the second particle. Comparable to stop-motion filming techniques, it allows different parts of the interaction to be frozen in time, which allows a more detailed observation of the entire interaction.

Re-solidifying the material may comprise the step of cooling the barrier material. In case the barrier material is vitreous ice, the step of liquifying may comprise the step of locally heating the sample. The surrounding part of the heated material will still be cold. Heat from the heated part of the sample may then flow to the colder parts surrounding the heated part, so that the heated part may cool down once again. Cooling down may lead to re-vitrification of the heated part of the sample, and thus the heated part of the sample is re-solidified again. In this state, an observation on the interaction between the first particle and the second particle may be done.

In an embodiment, the method comprises the step of re-liquifying at least a part of the barrier material after the step of re-solidifying, and subsequently observing the resulting interaction between the first particle and the second particle.

In an embodiment, the time resolved charged particle microscopy comprises liquifying the barrier material at a first location, solidifying the barrier material at said first location, and observing an interaction between the first particle and the second particle at the first location. For obtaining further time resolved data, the method may include liquifying the barrier material at a second location, solidifying the barrier material at said second location, and observing an interaction between the first particle and the second particle at said second location. In other words, the sample comprises a plurality of first particles (or a plurality of particles of a first type), and a plurality of second particles (i.e. a plurality of particles of a second type). The particles of the first type and the particles of the second type are able to react with each other. Since there are a plurality of particles of the first type, and a plurality of particles of the second type, there is the potential of many interactions between the particles of the first type and the particles of the second type. Liquifying the barrier material at a first location allows a particle of the first type to interact with a particle of the second type, and it allows the resulting interaction to be observed. Then, liquifying the barrier material at a second location allows a further particle of the first type to interact with a further particle of the second type. So even though there are different particles at different locations, this method still allows the same interaction between particles of the first type and the second type to be studied.

In an embodiment, the liquifying of the barrier material at the second location is chosen to have a longer duration compared to the liquifying of the barrier material at the first location. This allows the observation of the resulting interaction at different time intervals. Doing this at different locations is relatively easy, compared to observing the interaction at a single location.

The embodiment above relates to a method of time-resolved charged particle microscopy, comprising the steps of:
- providing a sample for charged particle microscopy, wherein said sample comprises a plurality of particles of a first type and a plurality of particles of a second type, and wherein said sample comprises a barrier material that is arranged to substantially separate particles of the first type and particles of the second type;
- liquifying at least a part of the barrier material at a first location for enabling an interaction between at least one of the plurality of particles of the first type and at least one of the plurality of particles of the second type; and
- observing the resulting interaction between said at least one of the plurality of particles of the first type and said at least one of the plurality of particles of the second type in a charged particle microscope.

A further step of the method may comprise the step of liquifying at least a part of the barrier material at a second location for enabling an interaction between at least one further of the plurality of particles of the first type and at least one further of the plurality of particles of the second type.

Effectively, this allows time resolved charged particle microscopy to be performed on multiple, different, parts of the sample.

The method may be performed using standard electron microscopy sample grids, which are known to those skilled in the art. These grids contain so-called grid squares, which are sub-parts of the grid itself. The particles of the first type and the particles of the second type may be provided on such a grid, with the barrier material keeping the particles separate from each other. The barrier material on different parts of the grid may be liquified for different time values. For example, the barrier material at a first location (e.g. grid square 1) liquified for a given time t (which could be in the order of milliseconds, depending on the expected time scale of the interaction between the particles) after which it is solidified again. At a second location (e.g. grid square 2) the barrier material is liquified for a longer duration: e.g. 2*t. At a third location (e.g. grid square 3) the barrier material is liquified for an even longer duration: e.g. 3*t, and so on for a number of n locations: n*t. This allows the resulting interaction between the particles to be studied at n discrete time intervals, and on a single grid.

Alternatively, the different time intervals can be studied per sample carrier. For example: a first grid uses a liquifying time of 1*t, a second grid uses a liquifying time of 2*t, and an n^{th} grid uses a liquifying time of n*t.

As described herein, at least one of the first particle and the second particle is selected from the group consisting of: nanoparticles, bio-molecules, viruses, proteins, ligands and/or medicinal molecules.

In an embodiment, the sample is a cryo-electron microscopy sample and the barrier material comprises amorphous ice.

In an embodiment, the step of liquifying the barrier material is performed when the sample for charged particle microscopy is placed inside the charged particle microscope. The step of liquifying the barrier material is performed with the sample being present inside of the charged particle microscope. In other words, the sample can remain inside of the charged particle microscope during the liquifying phase, so that the resulting interaction can be observed immediately. Thus, the method may be performed fully inside of the charged particle microscope.

In an alternative embodiment, the step of liquifying the barrier material is performed when the sample for charged particle microscopy is external of the charged particle microscope. This way, a sample can be prepared post-observation of the resulting interaction.

According to an aspect, a method for preparing a sample for time-resolved charged particle microscopy is provided. The method comprises the step of providing a sample carrier for charged particle microscopy. The method further comprises the step of depositing a first particle, a second particle and a barrier material on the sample carrier. Here, the order of depositing the first particle, the second particle and the barrier material is such that said first particle is provided at a distance from said second particle and said barrier material is provided between said first particle and said second particle.

With the sample preparation method as described above, a method of preparing a sample for time-resolved charged particle microscopy is obtained that allows time-resolved charged particle microscopy according to the method as described herein to be performed.

The order of deposition, and variations thereon that comply with the definition above, will be clear for those skilled in the art. As an example, the first particle can be deposited first, after which the barrier material can be deposited on top of the first particle. Subsequently, the second particle can be deposited on top of the barrier material. Thus, in this embodiment, the first particle is deposited on said sample carrier before the step of depositing said second material. Additionally, the barrier material is deposited on said sample carrier before the step of depositing said second particle. By using this order, the first particle and second particle are separated from each other by means of the barrier material. The barrier material is provided in between the first particle and the second particle, and the first particle is provided at a distance from the second particle. Thus, the order of deposition described above leads to the ordering of the first particle, second particle and the barrier material as defined herein.

The order of deposition given above is merely an example, and further embodiments are conceivable and derivable for those skilled in the art. It is noted that further non-limiting examples of different orders of depositing that comply with the above definition will be described herein in more detail in the accompanying description of the drawings.

For a more thorough understanding of the present disclosure, and advantages thereof, reference is now made to the following descriptions taken in conjunction with the accompanying drawings, in which:
Fig. 1 shows a longitudinal cross-sectional view of a charged particle microscope, in particular a transmission charged particle microscope;
Fig. 2 shows a first embodiment of a sample for use in the time-resolved charged particle microscopy as described herein;
Fig. 3 shows a second embodiment of a sample for use in the time-resolved charged particle microscopy as described herein;
Fig. 4a shows an intermediate step for preparing a sample for use in the time-resolved charged particle microscopy as described herein;
Fig. 4b-c show third and fourth embodiments, respectively, of a sample for use in the time-resolved charged particle microscopy as described herein;
Fig. 5 shows a fifth embodiment of a sample for use in the time-resolved charged particle microscopy as described herein;
Fig. 6 shows a sixth embodiment of a sample for use in the time-resolved charged particle microscopy as described herein;
Fig. 7 shows a seventh embodiment of a sample for use in the time-resolved charged particle microscopy as described herein;
Fig. 8 shows an eight embodiment of a sample for use in the time-resolved charged particle microscopy as described herein;
Fig. 9 shows a ninth embodiment of a sample for use in the time-resolved charged particle microscopy as described herein;
Fig. 10 shows a tenth embodiment of a sample for use in the time-resolved charged particle microscopy as described herein;
Fig. 11 shows an eleventh embodiment of a sample for use in the time-resolved charged particle microscopy as described herein;
Fig. 12 shows a twelfth embodiment of a sample for use in the time-resolved charged particle microscopy as described herein;
Fig. 13 shows a thirteenth embodiment of a sample for use in the time-resolved charged particle microscopy as described herein;
Fig. 14a-d show different moments in time of an embodiment of the time-resolved charged particle microscopy method as disclosed herein.
Fig. 15 shows a further embodiment of a sample for use in the time-resolved charged particle microscopy as described herein;

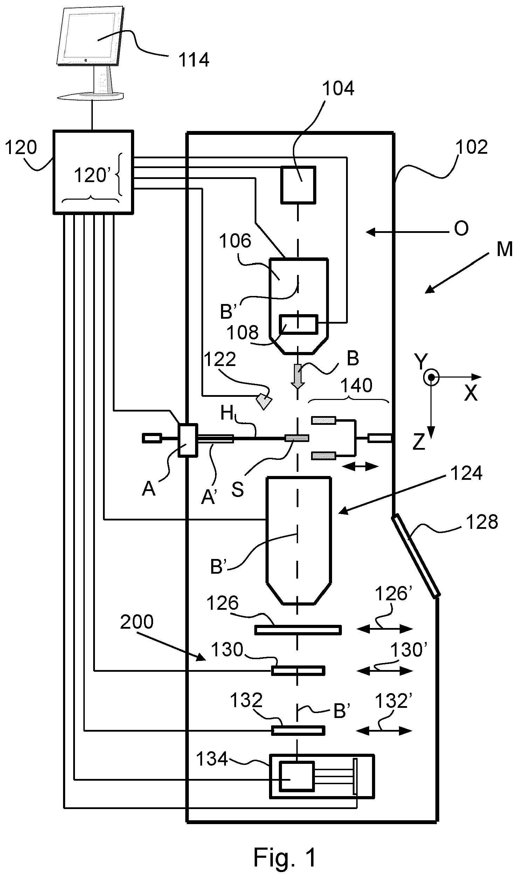

Fig. 1 (not to scale) is a highly schematic depiction of a charged-particle microscope M that can be used in the method as disclosed herein. More specifically, it shows an embodiment of a transmission-type microscope M, which, in this case, is a TEM/STEM. In Fig. 1, within a vacuum enclosure 102, an electron source 104 produces a beam B of electrons that propagates along an electron-optical axis B' and traverses an electron-optical illuminator 106, serving to direct/focus the electrons onto a chosen part of a sample S (which may, for example, be (locally) thinned/planarized). Also depicted is a deflector 108, which (*inter alia*) can be used to effect scanning motion of the beam B.

The sample S is held on a sample holder H that can be positioned in multiple degrees of freedom by a positioning device / stage A, which moves a cradle A' into which holder H is (removably) affixed; for example, the sample holder H may comprise a finger that can be moved (*inter alia*) in the XY plane (see the depicted Cartesian coordinate system; typically, motion parallel to Z and tilt about X/Y will also be possible). Such movement allows different parts of the sample S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the sample holder H, so as to maintain it (and the sample S thereupon) at cryogenic temperatures, for example.

The electron beam B will interact with the sample S in such a manner as to cause various types of "stimulated" radiation to emanate from the sample S, including (for example) secondary electrons, backscattered electrons, X-rays and optical radiation (cathodoluminescence). If desired, one or more of these radiation types can be detected with the aid of analysis device 122, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the sample S, exit/emanate from it and continue to propagate (substantially, though generally with some deflection/scattering) along axis B'. Such a transmitted electron flux enters a projection system (projection lens 124), which will generally comprise a variety of electrostatic / magnetic lenses, deflectors, correctors (such as stigmators), *etc.* In normal (non-scanning) TEM mode, this projection system 124 can focus the transmitted electron flux onto a fluorescent screen 126, which, if desired, can be retracted/withdrawn (as schematically indicated by arrows 126') so as to get it out of the way of axis B'. An image (or diffractogram) of (part of) the sample S will be formed by projection system 124 on screen 126, and this may be viewed through viewing port 128 located in a suitable part of a wall of enclosure 102. The retraction mechanism for screen 126 may, for example, be mechanical and/or electrical in nature, and is not depicted here.

As an alternative to viewing an image on screen 126, one can instead make use of the fact that the depth of focus of the electron flux leaving projection system 124 is generally quite large (*e.g*. of the order of 1 meter). Consequently, various other types of analysis apparatus can be used downstream of screen 126, such as:
- TEM detector (camera) 130. At camera 130, the electron flux can form a static image (or diffractogram) that can be processed by controller/processor 120 and displayed on a display device (not depicted), such as a flat panel display, for example. When not required, camera 130 can be retracted/withdrawn (as schematically indicated by arrows 130') so as to get it out of the way of axis B'.
- STEM detector (camera) 132. An output from camera 132 can be recorded as a function of (X,Y) scanning position of the beam B on the sample S, and an image can be constructed that is a "map" of output from camera 132 as a function of X,Y. Camera 132 can comprise a single pixel with a diameter of *e.g*. 20 mm, as opposed to the matrix of pixels characteristically present in camera 130. Moreover, camera 132 will generally have a much higher acquisition rate (*e.g*. 10⁶ points per second) than camera 130 (*e.g*. 10² images per second). Once again, when not required, camera 132 can be retracted/withdrawn (as schematically indicated by arrows 132') so as to get it out of the way of axis B' (although such retraction would not be a necessity in the case of a donut-shaped annular dark field camera 132, for example; in such a camera, a central hole would allow flux passage when the camera was not in use).
- As an alternative to imaging using cameras 130 or 132, one can also invoke spectroscopic detector 134, which could be an EELS module, for example.

It should be noted that the order/location of items 130, 132 and 134 is not strict, and many possible variations are conceivable. For example, spectroscopic detector 134 can also be integrated into the projection system 124.

In the embodiment shown, the microscope M further comprises a retractable X-ray Computed Tomography (CT) module, generally indicated by reference 140. In Computed Tomography (also referred to as tomographic imaging) the source and (diametrically opposed) detector are used to look through the sample along different lines of sight, so as to acquire penetrative observations of the sample from a variety of perspectives.

Note that the detectors 130,132, 134 are part of an imaging system (generally indicated with reference sign 200). The imaging system is arranged for generating an image signal based on information from the charged particle detector 130, 132, 134, and can be part of that detector or be a separate part from that detector. The controller (computer processor) 120 is connected to various illustrated components *via* control lines (buses) 120'. This controller 120 can provide a variety of functions, such as synchronizing actions, providing setpoints, processing signals, performing calculations, and displaying messages/information on a display device (not depicted). Needless to say, the (schematically depicted) controller 120 may be (partially) inside or outside the enclosure 102, and may have a unitary or composite structure, as desired.

The skilled artisan will understand that the interior of the enclosure 102 does not have to be kept at a strict vacuum; for example, in a so-called "Environmental TEM/STEM", a background atmosphere of a given gas is deliberately introduced / maintained within the enclosure 102. The skilled artisan will also understand that, in practice, it may be advantageous to confine the volume of enclosure 102 so that, where possible, it essentially hugs the axis B', taking the form of a small tube (*e.g*. of the order of 1 cm in diameter) through which the employed electron beam passes, but widening out to accommodate structures such as the source 104, sample holder H, screen 126, camera 130, camera 132, spectroscopic detector 34, *etc.*

Thus, the charged particle microscope M shown in Fig. 1 comprises a charged particle optical column O for directing a charged particle beam B onto a sample; a sample holder H for holding a sample S; and a charged particle detector 122, 126, 130, 132, 134 with an imaging system 200 for generating an image signal based on information from the charged particle detector.

The charged particle microscope M shown in Fig. 1 can be arranged to be suitable for time-resolved charged particle microscopy. The charged particle microscope M shown in Fig. 1 can be arranged for so called Cryo Electron Microscopy, where samples are studied at cryogenic conditions. The skilled person will be familiar with both these aspects of charged particle microscopy.

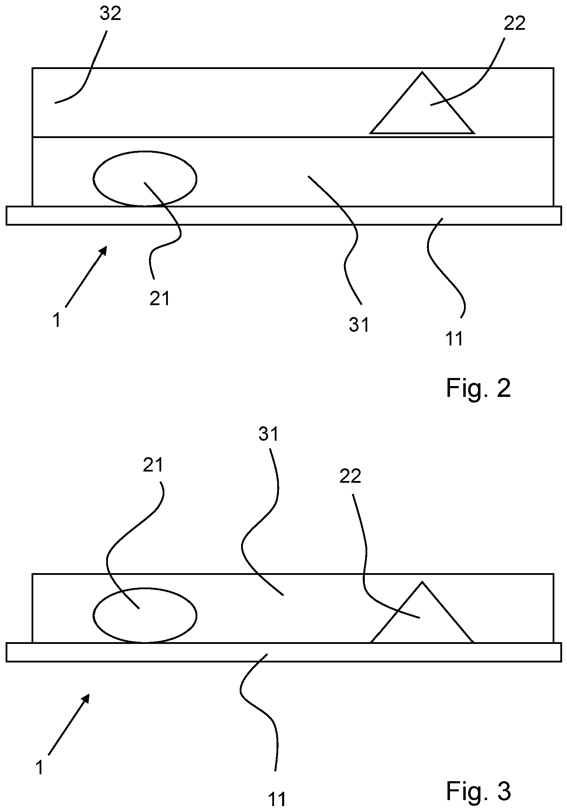

Now turning first to Fig. 2, a first embodiment of a sample 1 for use in time-resolved charged particle microscopy is shown. The sample 1 comprises a first particle 21, and a second particle 22. The first particle 21 and second particle 22 are chosen as a desired study object to study the biological and/or chemical interaction between the two particles. The particles 21, 22 are separated from each other. In the embodiment shown, the separation is established by two intermediate layers 31, 32. The first intermediate layer 31 encapsulates the first particle 21. The second intermediate layer 32 encapsulates the second particle 22. By means of the two intermediate layers 31, 32 the first particle and the second particle are separated from each other. The intermediate layers 31, 32 thus form a barrier material that extends between said first particle and said second particle. The barrier material, in this embodiment, is such that said first particle 21 is provided at a distance from said second particle 22 and said barrier material 31, 32 is at least partly provided between said first particle 21 and said second particle 22.

The barrier material 31 ensures that the first particle 21 and the second particle cannot reach each other and thus prevents interactions to take place between the first particle 21 and the second particle 22.

It is noted that in Fig. 2, each intermediate layer 31, 32 respectively forms a separate barrier material 31, 32. It is possible, however, that only one of the layers 31, 32 effectively forms a barrier material.

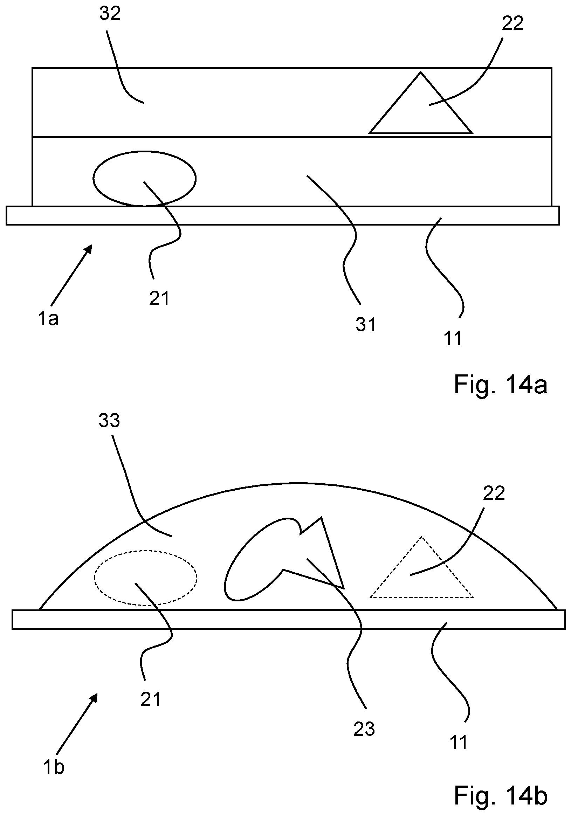

Now turning to Fig. 14a-14d, an embodiment of the time-resolved charged particle microscopy method will be explained. Here, use is made of the sample 1 that was previously described under reference to Fig. 2.

Fig. 14a shows the situation of the sample 1a before the experiment (i.e. similar to the sample described above with respect to Fig. 2), and having a first particle 21, a second particle 22 and a barrier material 31, 32 (here formed by two separate intermediate layers 31, 32) that is positioned between the first particle 21 and the second particle 22. The barrier material 31, 32 is arranged to keep the first particle 21 and second particle 22 at a distance from each other. This can be achieved, for example, by having a solid barrier material. In an embodiment, the solid barrier material can be vitreous ice, which is advantageous for use in cryo-EM experiments.

Fig. 14a shows a relatively static initial situation, which static initial situation can be maintained for a desired amount of time.

Fig. 14b shows the sample 1b during a first step of the experiment. Here, the barrier material 31 is liquified in order to obtain a liquified barrier material 33. The barrier properties of the liquified barrier material 33 are significantly reduced when compared to the barrier material 31, so that particles 21, 22 can move through the liquified barrier material 33, for example by means of Brownian motion. The reduced barrier properties allow the first particle 21 and the second particle 22 to interact with each other, which leads, in the embodiment shown, to a particle complex 23 (the first particle 21 is connected to the second particle 22, dashed lines indicate the original positions of the first and second particles 21, 22).

Obtaining the liquified barrier material 33 may be done, in an embodiment, by applying heat to the barrier material 31. By heating the barrier material 31, this material will become more fluid or liquid, so that the barrier properties of the barrier material 31 are reduced. Applying heat may be done very locally, so that non-heated parts of the sample remain in the static initial situation (as shown in Fig. 14a).

It is noted, in this respect, that the samples shown throughout the Figs. only show a single first particle 21 and a single second particle 22. It will be clear to those skilled in the art, however, that most samples comprise a vast amount of these particles.

The sample 1b shown in Fig. 14b can be studied with a charged particle microscope M. This allows the particle complex 23 formed by the interaction of the first particle 21 and the second particle 22 to be observed in an electron microscope, for example.

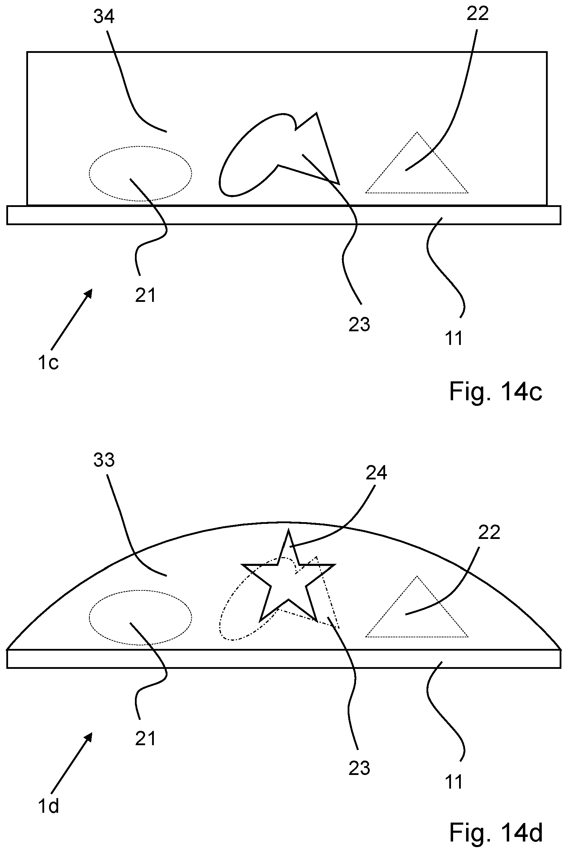

To enhance the observability of the sample 1b, it is possible to resolidify the liquified barrier material 33. This situation is shown in Fig. 14c. Here, the liquified barrier material 33 shown in Fig. 14b is resolidified, and with that the barrier properties of the barrier material 31 are at least partly restored. The barrier properties of the barrier material 31 originally ensured that the first particle 21 and the second particle 22 are kept at a distance from each other. In the embodiment shown in Fig. 14c, the restored barrier properties of the resolidified barrier material 34 ensure that the particle complex 23 will be conserved, so that the particle complex 23 can be easily studied in the charged particle microscope M.

Resolidifying the liquified barrier material 33 may be done, in an embodiment, by cooling the liquified barrier material 33. Cooling is relatively easy to apply, especially to a locally heated barrier material 31. The surrounding material of the sample 1 may be used to cool the locally heated barrier material 31.

In an embodiment, the sample is a cryo-EM sample at cryogenic temperature (i.e. at or below -150 degrees Celsius). By locally heating the sample to liquify the barrier material (i.e. vitrified ice, reheating to at or above 0 degrees Celsius) at a specific location, the surrounding part of the sample remains cold. The residual heat can be conducted into the surrounding cold parts of the sample, which will lead to re-solidification of the previously molten vitreous ice.

For observing different moments in time of a given interaction between a first particle 21 and a second particle 22, the steps indicated for Fig. 14a-14c may be repeated, at least once.

Fig. 14d shows a situation wherein the re-solidified barrier material 34 of Fig. 14c is liquified again, so that liquified barrier material 33 is obtained. The (intermediate) particle complex 23, formed by the interaction of the first particle 21 and the second particle 23, is able to finish the transformation process so as to form final particle complex 24. This final particle 24 may be observed in the charged particle microscope M in the state shown in Fig. 14d, or alternatively the liquified barrier material 33 can be re-solidified again (not shown).

Thus, the method as described herein allows time-resolved charged particle microscopy to be performed on the interaction of the first particle 21 and the second particle 22, allowing intermediate particles 23 and final particles 24 to be observed and imaged. It will be understood that the steps of liquifying the barrier material (by locally applying heat) and resolidifying the barrier material (by cooling, for example through heat conduction of residual heat to the sample surroundings) can be done multiple times, in a very controlled manner, to allow a relatively small time-step between each observation. This allows time-resolved charged particle microscopy with a relatively high temporal resolution to be obtained.

Examples of samples for use in the method as described in Fig. 14a-14d, and how to prepare them, will be discussed by means of Fig. 2 to 13.

As previously noted, Fig. 2 shows a first embodiment of a sample 1 for use in time-resolved charged particle microscopy. The sample 1 comprises a first particle 21, and a second particle 22, and are separated from each other by means of two intermediate layers 31, 32. These intermediate layers 31, 32 function as the barrier that extends between said first particle 21 and said second particle 22.

This embodiment can be prepared by providing a sample carrier 11, and then first forming a layer of the first intermediate layer 31 containing first particles 21, and then secondly forming a layer of the second intermediate layer 32 containing second particles 22 on top of the first intermediate layer 31. The first intermediate layer 31 may be formed by providing a liquid layer containing the first particles 21; and applying the solution to the sample carrier 11. After application of the solution, the layer can be solidified, for example by means of vitrifying the layer (a technique that is known from preparation of biological samples in Cryo-EM). After solidifying the first layer 31, the second layer 32 containing the second particles 22 can be applied on top of the first layer 31. After application, the second layer 32 can be solidified as well, for example by means of vitrifying the second layer 32.

Other techniques for preparing the multi-layered sample as shown in Fig. 2 can be used as well. For example, the first layer 31 containing the first particles 21, such as nanoparticles, may be a relatively viscous liquid at room temperature, containing hardeners so that after application of the layer to the grid 11, the layer substantially solidifies. The same can be done for the second layer 31 containing the second particles 22. During the experiment, the solidified layers can be liquified by means of heat or solvents, or the like. This technique is in particular suitable for nanoparticles.

Fig. 3 shows a second embodiment of a sample 1 that can be used in the method as described herein. Once again, the sample 11 contains a first particle 21, a second particle 22 and a barrier material 31 that is provided in between the first particle 21 and the second particle 22.

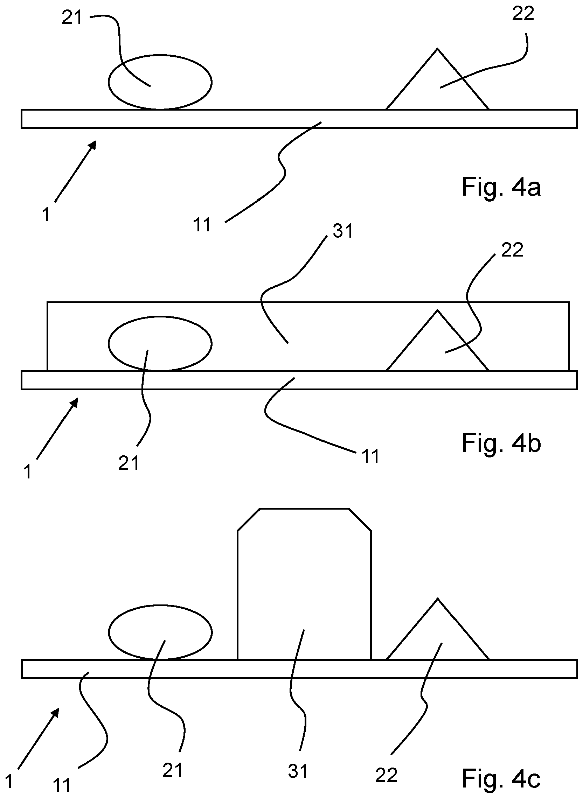

Fig. 4a and 4b show the steps of preparing the sample of Fig. 3. In Fig. 4a, the sample carrier 11 is provided, and first and second particles 21, 22 are deposited on a surface of the sample carrier 11. Due to the fact that the particles 21, 22 are deposited on the surface of the sample carrier, they are unlikely to interact with each other (movement of the particles 21, 22 is limited). To allow movement, for example by means of Brownian motion, a medium is needed, which is formed by the liquified barrier material 31. The liquified barrier material 31 allows for Brownian motion of the first particle 21 and second particle 22 within said medium 31.

The barrier material 31 can be applied by depositing a liquid on top of the sample carrier 11 having the first and second particle deposited thereon. The liquid can then be solidified, for example by means of cooling the liquid to a temperature at or below -150 degrees for biological samples, so as to reach the static initial state mentioned in Fig. 14a. This way, the state as shown in Fig. 4b can be reached.

In another embodiment, shown in Fig. 4c, the barrier material 31 is deposited, in the form of large solid pillars 31, on top of the sample carrier 11. In the event of a vast number of particles 21, 22 that are deposited on the sample carrier 11, depositing an equally vast number (or substantially same order) of barrier material pillars 31 on top of the sample carrier will naturally lead to the barrier material 31 being present between sets of first particles 21 and second particles 22. In the embodiment shown in Fig. 4c, liquifying the barrier material 31 will cause it to flow and merge with the first and second particle 21, 22 so that an interaction may take place between the first particle 21 and the second particle 22.

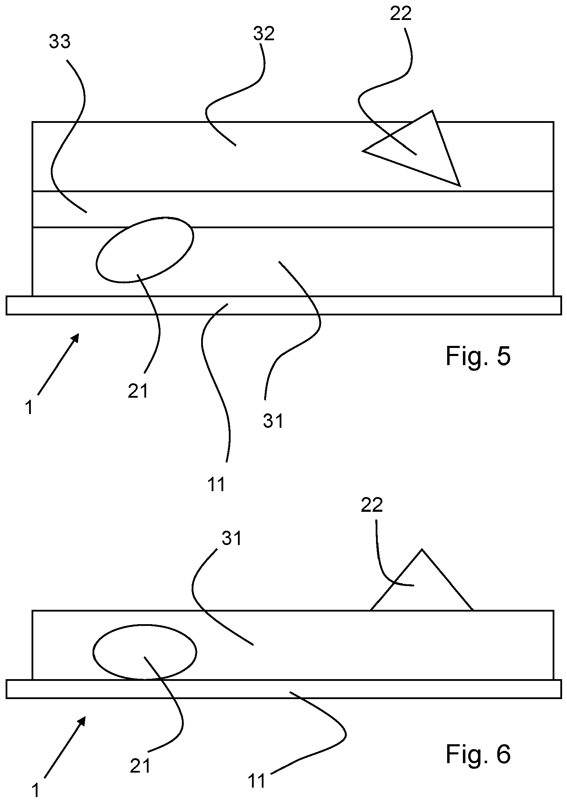

Fig. 5 shows an embodiment having a first layer of a barrier material 31 containing first particles 21, a second layer of a barrier material 32 containing second particles 22, and an intermediate layer 33 provided in between the first layer and the second layer. The intermediate layer 33 may provide a buffer layer 33 that prevents direct contact between the first particle 21 and the second particle 22. This direct contact may be possible when the first layer is relatively thin, so that first particles may be slightly misaligned and extend towards an outer surface of the layer. When the second layer 32 would be applied directly on top of the first layer 31, the second particle 22 may already interact with the first particle 21, without the interaction being observable inside the charged particle microscope.

The first layer, the second layer, and the intermediate layer may all be similar. Alternatively, they can be chosen to differ from each other. In an embodiment, the first material 31, the second material 32, and the intermediate layer 33 are all vitreous ice. Having the same material aids in locally liquifying the barrier material 31, 32, 33.

Fig. 6 shows an embodiment wherein the first particle 21 is applied to the sample carrier 11 in the form of a barrier material layer 31 containing said first particle 21. The second particle 22 is deposited on top of the barrier material 31, without being embedded in a respective barrier material.

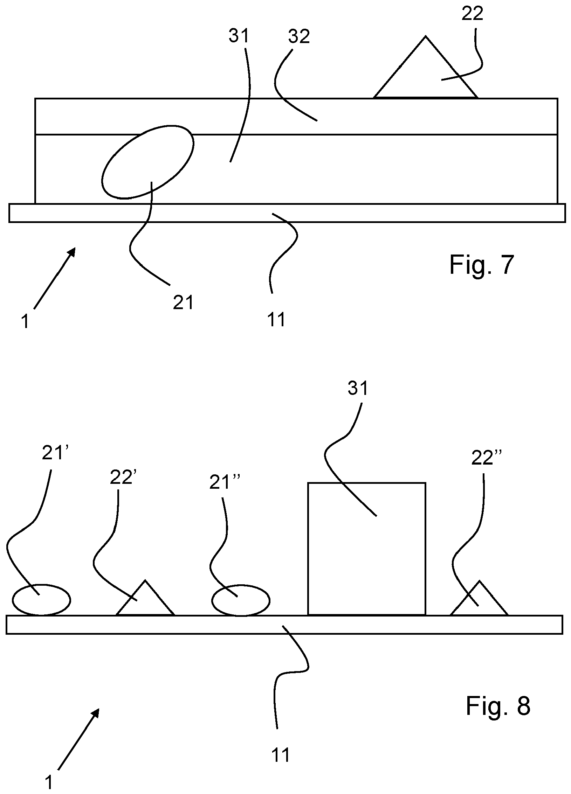

Fig. 7 shows the embodiment of Fig. 6, but with the inclusion of an intermediate layer 32 to prevent unintended interactions between the first and second particles 21, 22.

Fig. 8 shows an embodiment with a number of first particles 21',21" and second particles 22',22" being deposited on top of the sample carrier, and the barrier material being provided, in the form of bigger pillars 31, in between the number of particles. It can be seen, similar to Fig. 4c, that the barrier material 31 is provided between a set of first 21" and second 22" particles. The barrier material 31 that said first particle 21" is provided at a distance from said second particle 22" and said barrier material is provided between said first particle 21" and said second particle 22".

By liquifying the barrier material 31 of Fig. 8, the medium will flow and take up the first and second particles, so that interactions between particles 21',21", 22', 22" may take place.

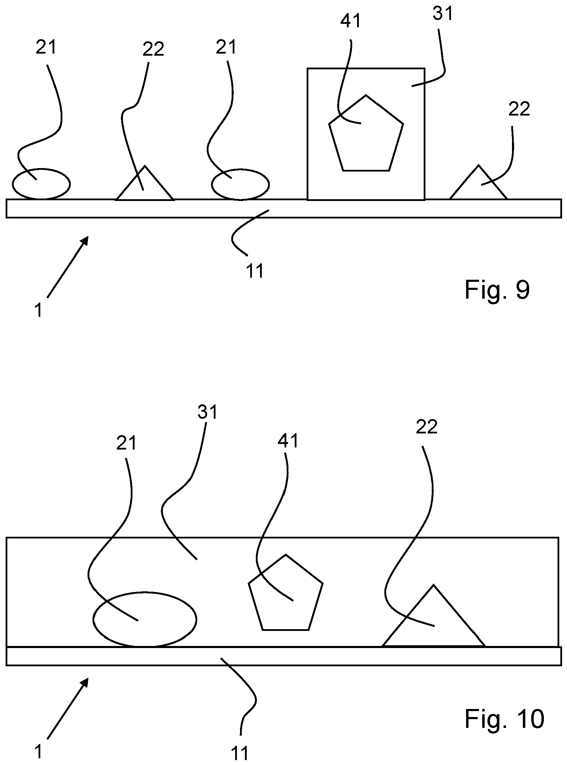

Fig. 9 shows an embodiment similar to Fig. 8, but here the barrier material is provided with a heat absorbing element 41 which aids in liquifying the barrier material 31. The heat absorbing element 41 may comprise gold particles, for example. By heating the heat absorbing element 41, for example by a laser or by the charged particle source, such as the electron source, the heat may be acquired in the heat absorbing particle 41 and then be released to the surrounding barrier material 31, which can then liquify as a result of the heat administered to it. Once liquified, the barrier material may include the particles such that an interaction between the particles may occur.

Fig. 10 shows an embodiment similar to Fig. 3, but with the provision of heat absorbing elements 41, similar to Fig. 9. This embodiment can be made similar as discussed with respect to Fig. 4, wherein the application of the barrier material 31 comprises the application of the barrier material 31 including heat absorbing elements 41, such as gold nanoparticles.

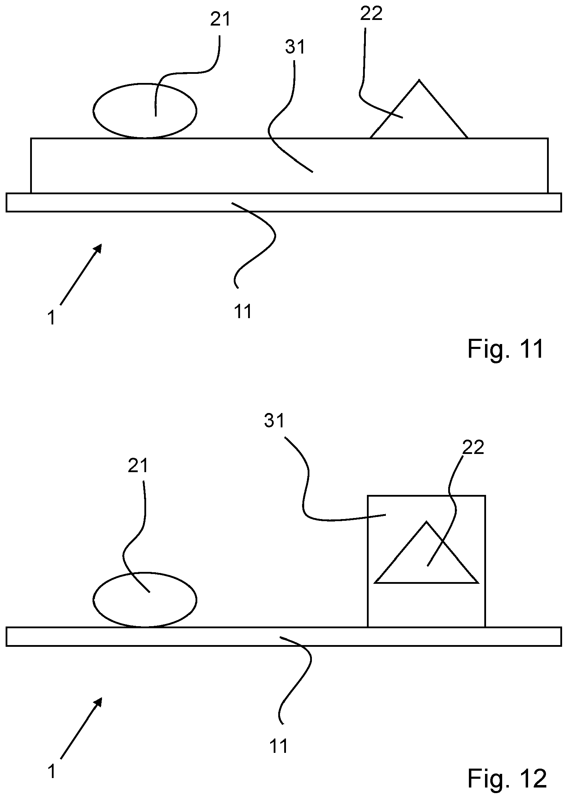

Fig. 11 shows a further embodiment, wherein the sample 1 is prepared by providing a sample carrier 11, then applying a layer of the barrier material 31, for example using standard cryo-EM sample preparation techniques as are known to those skilled in the art. After applying the layer 31 and solidifying the layer, the first particle 21 and the second particle 22 can be deposited on top of the barrier material layer. This results in the barrier material 31 being provided between the first particle 21 and the second particle 22. Upon liquification of the barrier material 31, the first particle 21 and the second particle 22 can be taken up by the liquid barrier material 31 to allow them to contact each other for starting an interaction.

Fig. 12 shows yet another embodiment of a sample 1, wherein the first particle 21 is deposited on top of the sample carrier 11, and the barrier material 31 containing the second particle 22 is deposited on top of the sample carrier 11 as well. Here, the barrier material 31 is (at least partly) provided between the first particle 21 and the second particle 22, so that the first particle 21 and the second particle 22 are not able to contact each other.

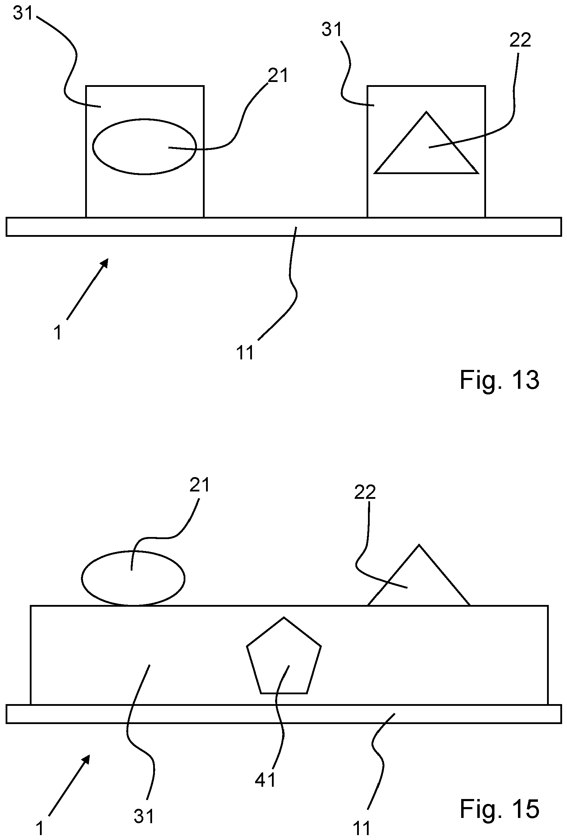

Fig. 13 shows an alternative to the sample 1 of Fig. 12, wherein both the first particle 21 and the second particle 22 are embedded within the barrier material 31. The pillar of the barrier material 31 containing the respective particle 21, 22 is then deposited on top of the sample carrier 11.

Fig. 15 shows an alternative to sample 1 as described by means of Fig. 11, but containing additional heat absorbing elements 41.

The method for time-resolved charged particle microscopy, and the method for preparing samples for that method, may comprise, in an embodiment that uses cryogenic temperatures for solidifying the barrier material, the steps of:
1) Preparing samples using cold deposition of (bio)molecules and/or particles 21, 22 to form an ice layer 31 on a cold carrier 11; with
2) a de-freezing period of the ice layer (barrier material 31) to allow dynamics in the liquid phase, in particular interaction of the molecules/particles 21, 22; followed by
3) refreezing (re-vitrification) of the barrier material 31 to fixate the final state in vitreous ice for cryo-EM imaging.

For depositing the particles on the sample 1, soft landing deposition [1] or shock-freezing deposition [2] can be used to deposit either hydrated or ice-covered biomolecules and/or particles on a bare carrier 11 (see Fig. 4a, 8, 9, 12, 13) or on a carrier 11 pre-covered with ice 31 or sample in vitreous ice (see Fig. 6, 7, 11, 15).

These deposition methods allow the sequential or simultaneous deposition of multiple reactants (particles 21, 22) either cold or as ice-embedded, without the substantial occurrence of dynamics, mixing and/or chemical reactions.

By using a subsequent ultra-short heating step of the deposited, frozen sample to the liquid phase, the reactants' molecules or particles can diffuse and react.

As the bulk of the carrier remains cold the liquified barrier material instantly freezes (re-vitrifies) after heating is stopped. The short de-freezing and re-vitrification by application of short laser heating for example is known to those skilled in ther art [3-6]. Other heating method may be used as well. For example, the sample carrier 11 may be provided with an integrated microheater (not shown) that is able to (locally) heat the grid 11 to liquify the barrier material 31.

The method as disclosed herein allows time-resolved biochemistry experiments using charged particle microscopy, in particular using cryo-EM. The cold deposition of the samples prevents dynamics and reaction, the subsequent melting and re-vitrification step allows dynamics and reaction and provides a defined t=0s state and temporal control.

### Cited literature

[1] A Preparative Mass Spectrometer to Deposit Intact Large Native Protein Complexes, Paul Fremdling, Tim K. Esser, Bodhisattwa Saha, Alexander A. Makarov, Kyle L. Fort, Maria Reinhardt-Szyba, Joseph Gault,and Stephan Rauschenbach,, ACS Nano2022, 16, 1444314455
[2] Controlled beams of shock-frozen, isolated, biological and artificial nanoparticles, Amit K. Samanta , Muhamed Amin , Armando D. Estillore , Nils Roth , Lena Worbs , Daniel A. Horke, and Jochen Kupper, Structural Dynamics 7, 024304 (2020)

## Claims

1. Method of time-resolved charged particle microscopy, comprising the steps of:
- providing a sample for charged particle microscopy, wherein said sample comprises a first particle and a second particle, and wherein said sample comprises a barrier material between said first particle and said second particle;
- liquifying at least a part of the barrier material for enabling an interaction between the first particle and the second particle; and
- observing the resulting interaction between the first particle and the second particle in a charged particle microscope.

2. Method according to claim 1, wherein the step of liquifying the barrier material comprises the step of heating said barrier material.

3. Method according to claim 2, wherein a laser is used for liquifying the barrier material.

4. Method according to claim 2, wherein a charged particle beam is used for liquifying the barrier material.

5. Method according to claim 4, wherein the sample comprises heat absorbing particles, in particular gold particles, wherein the charged particle beam is used to heat the heat absorbing particles for subsequently liquifying the barrier material.

6. Method according to claim 1-5, comprising the step of re-solidifying the barrier material, after the step of liquifying said barrier material.

7. Method according to claim 6, wherein the step of re-solidifying the barrier material comprises the step of cooling the barrier material.

8. Method according to claim 6 or 7, comprising the subsequent step of re-liquifying at least a part of the barrier material after the step of re-solidifying, and subsequently observing the resulting interaction between the first particle and the second particle.

9. Method according to claim 1-8, wherein at least one of the first particle and the second particle is selected from the group consisting of: nanoparticles, bio-molecules, viruses, proteins, medicinal molecules, ligands.

10. Method according to claim 1-9, wherein the sample is a cryo-electron microscopy sample and the barrier material comprises amorphous ice.

11. Method according to claim 10, wherein the step of liquifying the barrier material is performed when the sample for charged particle microscopy is placed inside the charged particle microscope.

12. Method of preparing a sample for time-resolved charged particle microscopy, comprising the steps of:
- providing a sample carrier for charged particle microscopy;
- depositing a first particle, a second particle and a barrier material on the sample carrier, wherein the order of depositing the first particle, the second particle and the barrier material is such that said first particle is provided at a distance from said second particle and said barrier material is provided between said first particle and said second particle.

13. Method according to claim 12, wherein said barrier material is deposited on said sample carrier before the step of depositing said second particle.

14. Method according to claim 12 or 13, wherein said barrier material is deposited on said sample carrier before the step of depositing said second material.
